(19) **Europäisches Patentamt / European Patent Office / Office européen des brevets**

(11) **EP 3 044 858 B1**

(12) # FASCICULE DE BREVET EUROPEEN

(45) Date de publication et mention de la délivrance du brevet:
**21.07.2021 Bulletin 2021/29**

(21) Numéro de dépôt: **14777698.3**

(22) Date de dépôt: **03.09.2014**

(51) Int Cl.:
*H05K 7/20* (2006.01)    *H02K 11/04* (2016.01)

(86) Numéro de dépôt international:
**PCT/FR2014/052177**

(87) Numéro de publication internationale:
**WO 2015/033062 (12.03.2015 Gazette 2015/10)**

(54) **ENSEMBLE ELECTRONIQUE POUR MACHINE ELECTRIQUE TOURNANTE POUR VEHICULE AUTOMOBILE**

ELEKTRONISCHE BAUGRUPPE FÜR EINE ELEKTRISCHE DREHMASCHINE FÜR EIN KRAFTFAHRZEUG

ELECTRONIC ASSEMBLY FOR A ROTARY ELECTRIC MACHINE FOR A MOTOR VEHICLE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.09.2013 FR 1358616**

(43) Date de publication de la demande:
**20.07.2016 Bulletin 2016/29**

(73) Titulaire: **Valeo Equipements Electriques Moteur 94046 Créteil Cedex (FR)**

(72) Inventeurs:
• **FALGUIER, Manuel**
  **F-94100 Saint-Maur des Fossés (FR)**
• **HOSNI, Alexis**
  **F-77500 Chelles (FR)**

• **FAKES, Michel**
  **F-59113 Seclin (FR)**
• **GUERIN, Fabien**
  **F-92320 Chatillon (FR)**
• **LE-MEITOUR, Yannick**
  **F-92290 Châtenay Malabry (FR)**
• **BAUDESSON, Philippe**
  **F-27220 La Boissière (FR)**

(74) Mandataire: **Novembre, Christophe Adelphe Valeo Systèmes de Contrôle Moteur 14, avenue des Béguines Immeuble le DELTA 95800 Cergy St Christophe (FR)**

(56) Documents cités:
**WO-A1-2012/108398    WO-A1-2013/061404
JP-A- 2010 187 504    JP-A- 2010 187 504
US-A1- 2014 070 645**

**Description**

DOMAINE TECHNIQUE DE L'INVENTION

La présente invention concerne un ensemble électronique pour machine électrique tournante pour véhicule automobile. La présente invention concerne également une machine électrique tournante comportant un tel ensemble électronique. Elle trouve une application particulière mais non limitative dans le domaine des alterno-démarreurs de véhicule automobile, par exemple pour des alterno-démarreurs ou moteur-générateurs adaptés pour des applications véhicule de type « mild-hybrid ».

ARRIÈRE-PLAN TECHNOLOGIQUE DE L'INVENTION

Dans un véhicule automobile comportant un moteur thermique et une machine électrique tournante telle qu'un alterno-démarreur, un telle machine comporte de manière non limitative :

- un rotor comprenant un inducteur dans lequel est amené un courant d'excitation ; et
- un stator comprenant un bobinage polyphasé.

L'alterno-démarreur fonctionne en mode moteur ou en mode générateur. C'est une machine dite réversible.

En mode alternateur appelé également mode générateur, la machine permet de transformer un mouvement de rotation du rotor entraîné par le moteur thermique du véhicule, en un courant électrique induit dans les phases du stator. Dans ce cas, un pont redresseur relié aux phases du stator permet de redresser le courant induit sinusoïdal en un courant continu pour alimenter des consommateurs du véhicule ainsi qu'une batterie.

Au contraire, en mode moteur, la machine électrique fait office de moteur électrique permettant d'entraîner en rotation, via l'arbre du rotor, le moteur thermique du véhicule. Il permet de transformer l'énergie électrique en énergie mécanique. Dans ce cas un onduleur permet de transformer un courant continu provenant de la batterie en un courant alternatif pour alimenter les phases du stator pour faire tourner le rotor.

Des composants de contrôle sont utilisés pour déterminer le mode de fonctionnement de la machine électrique tournante (mode moteur ou mode générateur) via des signaux de contrôle.

Les alterno-démarreurs qui intègrent une fonction de freinage récupératif et une fonction d'assistance du moteur thermique à l'accélération, appelés en anglais « mild-hybrid », intègrent en outre des composants de filtrage qui empêchent les composants de puissance de perturber le réseau électrique du véhicule automobile, en général un réseau de 48 Volts. Ces machines réversibles ont des puissances de l'ordre de 8 à 15kW.

Les composants de puissance (pont redresseur et onduleur), les composants de contrôle ainsi que les composants de filtrage génèrent de la chaleur. Il est ainsi nécessaire d'utiliser un dispositif de refroidissement pour dissiper cette chaleur émise par tous ces composants.

Le document WO13061404A1 décrit un ensemble électronique comprenant des composants de puissance et des composants de contrôle et un dispositif de refroidissement pour refroidir cet ensemble.

Dans le brevet FR2847085, il est décrit un ensemble électronique comprenant les composants de puissance et les composants de contrôle (appelés unités de commande), les deux ensembles de composants étant placés au plus près l'un de l'autre, et un dispositif de refroidissement pour refroidir cet ensemble. Le dispositif de refroidissement comprend :

- un dissipateur sur lequel sont montés les composants de puissance et de contrôle, le dissipateur étant disposé sur le palier arrière de la machine électrique et comprenant des ailettes situées sur sa face inférieure qui se trouve en vis-à-vis du palier. Il existe par ailleurs entre l'arbre de rotation du rotor et le dissipateur, un espace libre par lequel l'air peut circuler ;
- le palier arrière comprenant des ouïes radiales de sortie de l'air ; et
- un capot de protection comprenant des ouvertures situées sur le dessus dudit capot.

Ainsi, d'une part de l'air est aspiré latéralement dans l'alterno-démarreur et s'écoule vers les ouïes radiales de sortie du palier tout en léchant les ailettes du dissipateur, et d'autre part de l'air est aspiré par les ouvertures du capot puis s'écoule axialement le long de l'arbre de rotation (via l'espace libre) du rotor pour rejoindre un passage d'écoulement sous le dissipateur. Ainsi, l'ensemble des composants de puissance et de contrôle est refroidi.

Un inconvénient de cet état de la technique réside dans le fait que le refroidissement n'est pas optimisé par rapport aux besoins de dissipation propres des composants de puissance et de contrôle.

Dans ce contexte, la présente invention vise à résoudre l'inconvénient précédemment mentionné.

DESCRIPTION GENERALE DE L'INVENTION

A cette fin l'invention propose un ensemble électronique pour machine électrique tournante pour véhicule automobile.

L'invention est définie dans la revendication de dispositif 1. Des modes de réalisation préférés de l'invention sont décrits dans les revendications dépendantes 2-13.

BREVE DESCRIPTION DES FIGURES

L'invention et ses différentes applications seront mieux comprises à la lecture de la description qui suit et à l'examen des figures qui l'accompagnent.

- la figure 1a représente une vue éclatée en perspective d'un premier mode de réalisation non limitatif d'un ensemble électronique pour machine électrique tournante pour véhicule automobile selon l'invention ;
- la figure 1b représente une vue assemblée en perspective de l'ensemble électronique de la figure 1a ;
- la figure 2 représente une vue de dessus d'un bloc de puissance de l'ensemble électronique de la figure 1 ;
- la figure 3a représente une vue en perspective d'un module de puissance du bloc de puissance de la figure 2 ;
- la figure 3b représente une vue en perspective d'un module d'excitation du bloc de puissance de la figure 2 ;
- la figure 4 représente une vue en perspective d'un premier dissipateur couplé au bloc de puissance de la figure 2 ;
- la figure 5 représente une vue de dessous du premier dissipateur de la figure 4 ;
- la figure 6 représente une vue de profil du premier dissipateur des figures 4 et 5 ;
- la figure 7 représente une vue en perspective assemblée du bloc de puissance de la figure 2 avec le premier dissipateur des figures 4 à 6 ;
- la figure 8 représente une vue en perspective d'un bloc de filtrage de l'ensemble électronique de la figure 1 ;
- la figure 9 représente une vue d'un deuxième dissipateur couplé au bloc de filtrage de la figure 8 ;
- la figure 10 représente un mode de réalisation non limitatif d'assemblage du bloc de filtrage des figures 8 et9 avec le premier dissipateur des figures 4 à 6 sans les condensateurs ;
- la figure 11 représente le mode de réalisation d'assemblage de la figure 10 avec les condensateurs ;
- La figure 12 représente un zoom sur une partie de l'assemblage de la figure 11 ;
- la figure 13 représente un éclaté de l'assemblage du bloc de filtrage de la figure 11 ;
- la figure 14 représente une vue en perspective d'un bloc de contrôle de l'ensemble électronique de la figure 1 ;
- la figure 15 représente une vue de profil du bloc de contrôle de la figure 14 ;
- la figure 16 représente une vue de dessous du bloc de contrôle des figures 14 et 15 ;
- la figure 17 représente une vue en perspective d'un capot de protection de l'ensemble électronique de la figure 1 ;
- la figure 18 représente une vue de profil du capot de protection de la figure 17 ;
- la figure 19 représente une vue de dessus du capot de protection des figures 17 et 18 ;
- la figure 20 est un schéma explicatif des flux d'air générés par des ouvertures latérales du capot de protection des figures 17 à 19 ;
- la figure 21 est un schéma explicatif des ouvertures du capot de protection des figures 17 à 19 qui sont disposées en regard des ailettes du premier dissipateur des figures 4 à 6 et du deuxième dissipateur de la figure 9 ; et
- la figure 22 représente une machine électrique tournante comprenant l'ensemble électronique de la figure 1.

DESCRIPTION DE MODES DE REALISATION DE L'INVENTION

Les éléments identiques, par structure ou par fonction, apparaissant sur différentes figures conservent, sauf précision contraire, les mêmes références.

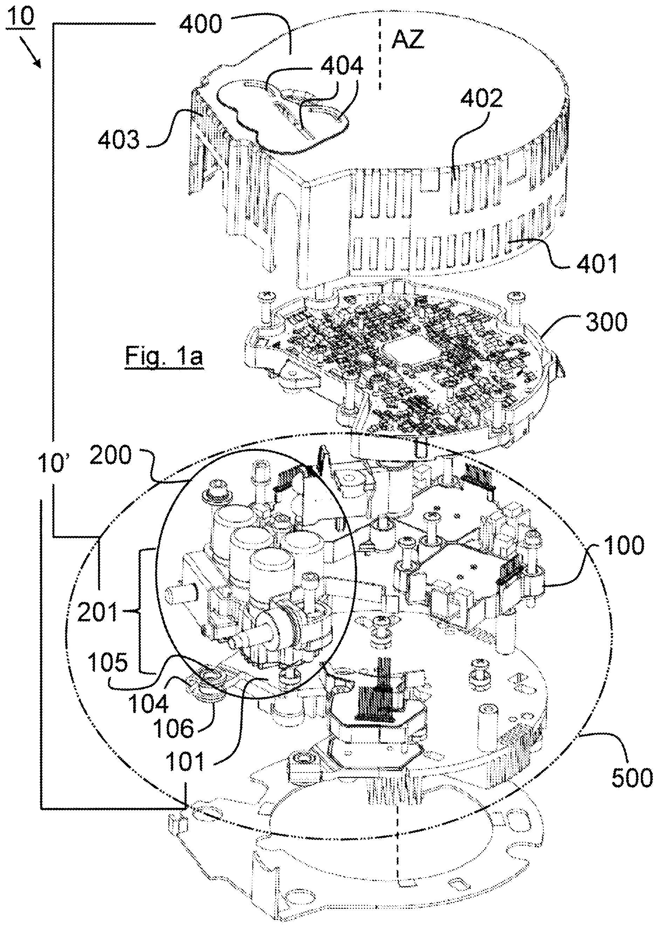

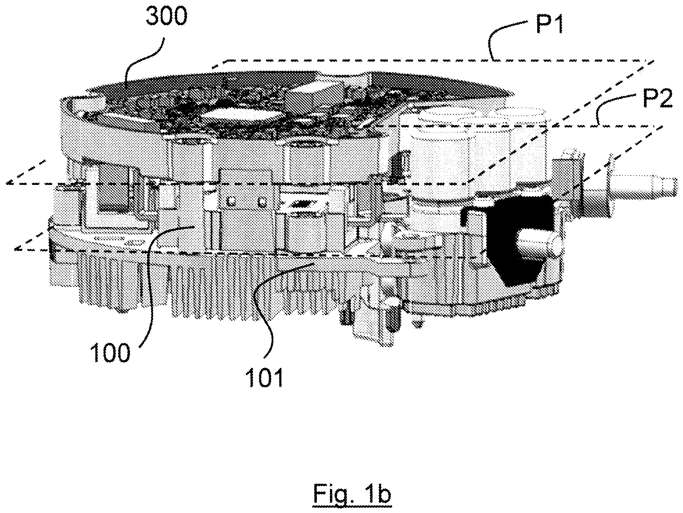

L'ensemble électronique 10 pour machine électrique tournante est décrit en référence aux figures 1 à 22.

La machine électrique tournante est dans un exemple un alterno-démarreur pour une application véhicule de type « mild-hybrid ». La machine électrique tournante est dans ce type d'application utilisée non seulement pour la génération électrique et le démarrage du moteur thermique (avec la fonctionnalité dite « Stop & Go » ou « Stop/Start » en anglais), mais également pour le freinage récupératif, la traction à faible vitesse du véhicule et l'assistance en couple du moteur thermique.

Tel qu'illustré à la figure 1, selon un mode de réalisation, l'ensemble électronique 10 comporte :

- des blocs 100, 200, 300 de composants électroniques, les blocs ayant des besoins de dissipation thermique différents, les blocs étant :

  - un bloc de puissance 100 ;

- un bloc de filtrage 200 ;
- un bloc de contrôle 300 ;

- un dispositif de refroidissement 10' desdits blocs 100, 200, 300, ledit dispositif de refroidissement 10' comportant :

  - un capot de protection 400 adapté pour recouvrir les blocs de puissance, de filtrage et de contrôle 100, 200, 300, ledit capot de protection comportant des ouvertures 401, 402, 403, 404 adaptées pour générer des flux d'air de refroidissement F1, F2, F3, F4 différents pour les besoins de dissipation thermique de chacun des blocs de puissance 100, de contrôle 300 et de filtrage 200 ;
  - et des éléments de refroidissement 101, 201, 301 couplés audit capot de protection 400.

Comme on va le voir en détail ci-après, grâce à l'architecture de l'ensemble électronique en blocs séparés, à la création des flux d'air différents pour refroidir les différents blocs, et au couplage entre les éléments de refroidissements aux ouvertures du capot, on obtient un découplage thermique entre les différents blocs et on optimise le refroidissement de chaque bloc. On a un refroidissement ciblé pour chaque bloc, chaque bloc ayant des températures de fonctionnement différentes et ayant ainsi des besoins de dissipation thermique différents. On obtient ainsi un meilleur refroidissement de l'ensemble électronique.

Dans un mode de réalisation,

- un premier élément de refroidissement est un premier dissipateur 101 muni d'une pluralité d'ailettes 1011 couplé audit bloc de puissance 100 ;
- un deuxième élément de refroidissement est un deuxième dissipateur 201 muni d'une pluralité d'ailettes 2011 couplé à des condensateurs 202 dudit bloc de filtrage 200 ;
- le bloc de contrôle 300 est disposé sur un premier plan P1 parallèle à un deuxième plan P2 sur lequel est monté le bloc de puissance 100 de sorte à permettre un passage d'un flux d'air de refroidissement F2 entre les deux blocs 100, 300 ;
- les ouvertures du capot de protection 400 sont réparties en :

  - un premier ensemble d'ouvertures 401 adaptées pour être positionnées en regard des ailettes du premier dissipateur 101 ;
  - un deuxième ensemble d'ouvertures 402 adaptées pour être positionnées en regard du bloc de contrôle 300 ; les deux ensembles d'ouvertures 401, 402 étant séparés par un muret de séparation 405 de sorte à créer un premier flux d'air de refroidissement radial F1 pour ledit bloc de puissance 100 et un deuxième flux d'air de refroidissement radial F2 pour ledit bloc de contrôle 300 ; et
  - un troisième ensemble d'ouvertures 403 adapté pour être positionné en regard des ailettes du deuxième dissipateur 201 de sorte à créer un troisième flux d'air de refroidissement radial F3 pour ledit bloc de filtrage 200.

Les différents éléments de l'ensemble électronique de puissance et de son dispositif de refroidissement 10', ainsi que les différents flux d'air générés, sont décrits plus en détail ci-après.

Bloc de puissance

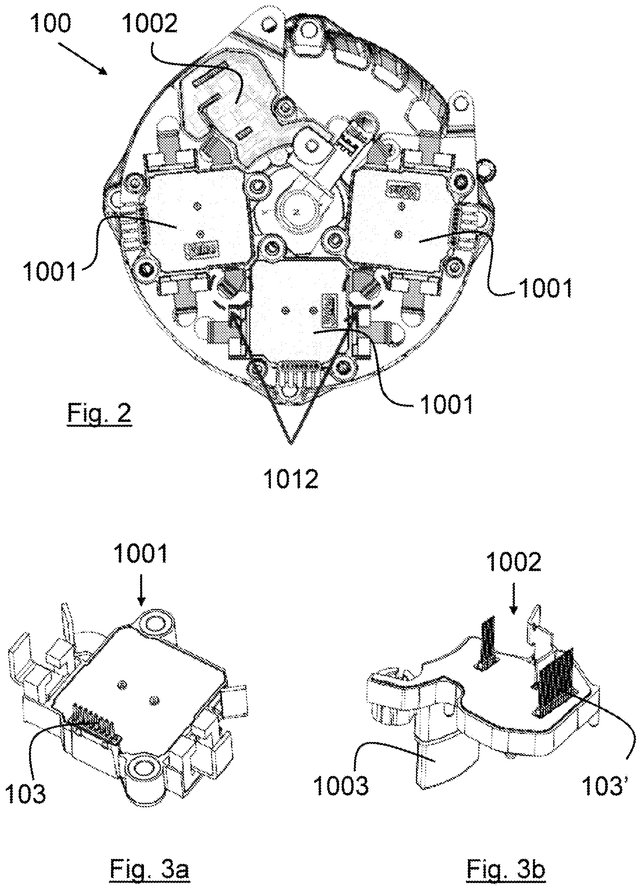

La figure 2 représente une vue de dessus du bloc de puissance 100. Dans cet exemple, le bloc de puissance 100 comprend trois modules de puissance 1001 et un module d'excitation 1002.

Les modules de puissance 1001 comprennent des interrupteurs électroniques, tels que dans un exemple des transistors MOSFET, les interrupteurs d'un module étant destinés à réaliser un bras de pont redresseur/onduleur pour une phase de la machine électrique tournante. Un exemple d'un module de puissance 1001 est représenté à la figure 3a. Il comporte des pins d'interconnexion 103 décrits plus loin dans la description.

Le module d'excitation 1002 permet d'alimenter la bobine du rotor de ladite machine, ledit module comprenant de manière classique, des transistors MOSFET et des diodes permettant de déterminer le courant dans le rotor. Un exemple d'un module d'excitation 1002 est représenté à la figure 3b. Il comporte des pins d'interconnexion 103' décrits plus loin dans la description. On peut également voir un capteur magnétique 1003 qui permet de déterminer la position du rotor.

Les modules de puissance 1001 et le module d'excitation 1002 étant des sources de chaleur, il est nécessaire de les refroidir.

A cet effet, le dispositif de refroidissement 10' comprend un premier élément de refroidissement qui est un premier dissipateur 101 (appelé également dissipateur de bloc de puissance) muni d'une pluralité d'ailettes 1011 couplé au bloc de puissance 100. Ces dernières sont dans un mode de réalisation, disposées sensiblement radialement sous le bloc de puissance 100. Elles sont de manière classique en aluminium.

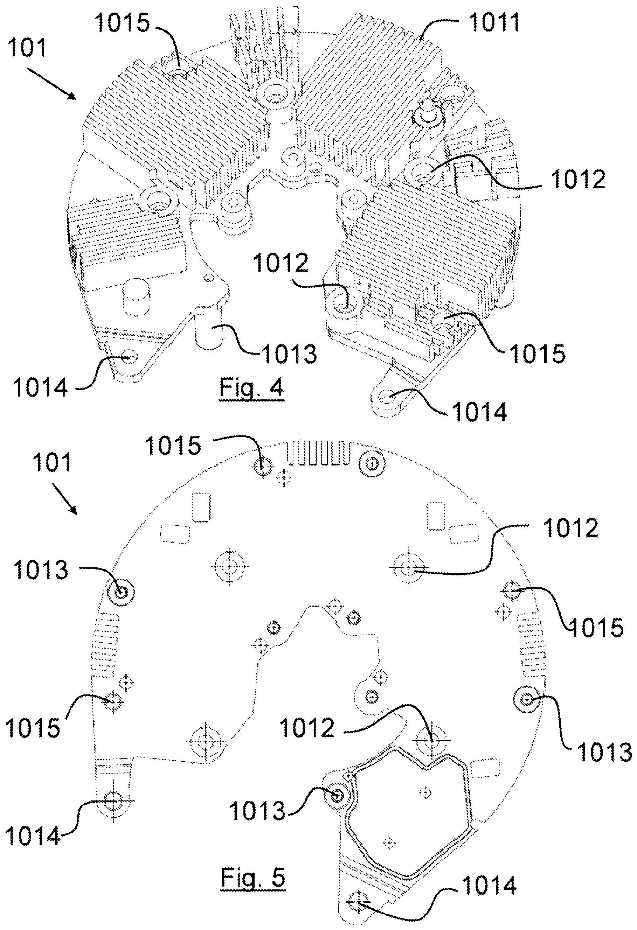

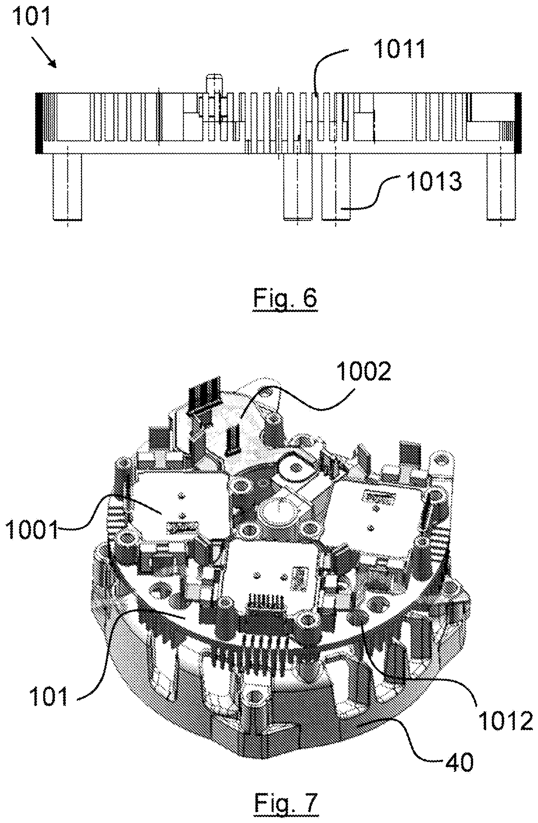

Les ailettes 1011 du premier dissipateur 101 sont représentées sur la vue en perspective de la figure 4 et la vue de profil du dissipateur de bloc de puissance 101 à la figure 6.

Ces ailettes vont permettre d'avoir une grande surface d'échange avec l'air qui traverse l'électronique.

Ainsi, comme on le verra par la suite, le refroidissement du bloc 100 sera optimisé grâce aux ailettes du dissipateur 101.

Outre les modules de puissance 1001 et d'excitation 1002, le bloc de puissance 100 comporte des traces conductrices qui permettent le passage de courant dans les composants. Ces traces conductrices sont également des sources de chaleur qu'il est nécessaire de refroidir.

On notera que le premier dissipateur 101 comporte en outre :

- une pluralité de plots de montage 1013 tels que représentés sur les figures 4 à 6, lesdits plots permettant de fixer le bloc de contrôle 300. Ces plots de montage 1013 servent d'entretoises entre les deux blocs 100 et 300. Le bloc de contrôle 300 est ainsi disposé sur un plan parallèle à celui du bloc de puissance 100. Dans un exemple, quatre plots sont utilisés.
- au moins deux pattes de montage munies d'orifices 1014 tels qu'illustrées sur les figures 4 et 5, ces pattes permettant de fixer le bloc de filtrage 200. Dans un exemple, deux pattes de montage sont utilisés. Le bloc de filtrage est décrit ci-après ;
- une pluralité d'orifices de montage 1015 tels que représentés sur les figures 4 à 6, lesdits orifices permettant de fixer le bloc de puissance 100. Dans un exemple, quatre orifices sont utilisés.

Bloc de filtrage

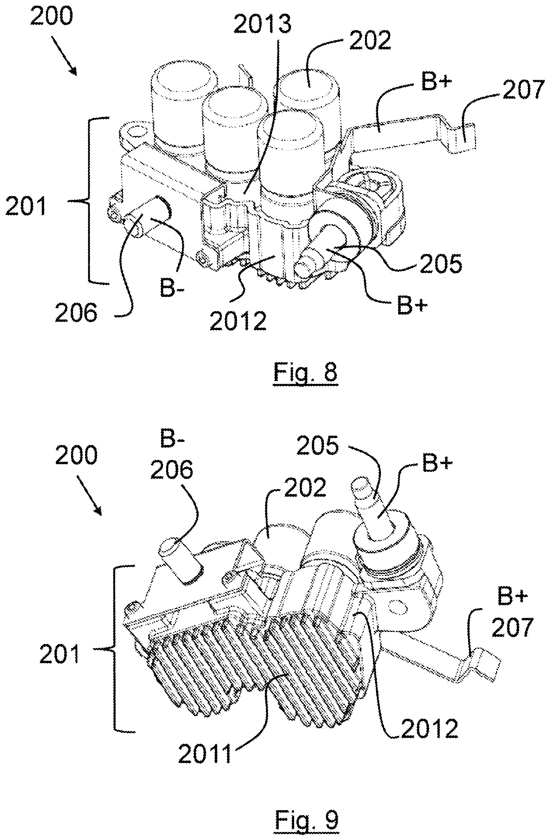

Le bloc de filtrage 200 est illustré sur les figures 8 à 13.

Comme illustré sur les figures 8 et 9, le bloc de filtrage 200 comporte une pluralité de condensateurs 202 destinées à filtrer les perturbations provenant des composants de puissance (modules de puissance 1001 notamment). Afin de refroidir les condensateurs 202, le dispositif de refroidissement 10' comprend un deuxième élément de refroidissement qui est un deuxième dissipateur 201 (appelé également dissipateur de bloc de filtrage) muni d'une pluralité d'ailettes 2011, ledit dissipateur étant couplé aux condensateurs 202.

Ces ailettes vont permettre d'avoir une grande surface d'échange avec l'air qui traverse l'électronique.

Ainsi, comme on le verra par la suite, le refroidissement du bloc 200 et donc des condensateurs 202 sera optimisé grâce aux ailettes du dissipateur 201.

Dans un mode de réalisation, le deuxième dissipateur 201 est couplé aux condensateurs 202 du bloc de filtrage 200 au moyen d'une résine 2013. Ainsi, la résine permet non seulement de maintenir lesdits condensateurs 202 dans le dissipateur mais également d'avoir une bonne évacuation des calories des condensateurs vers ledit dissipateur 201.

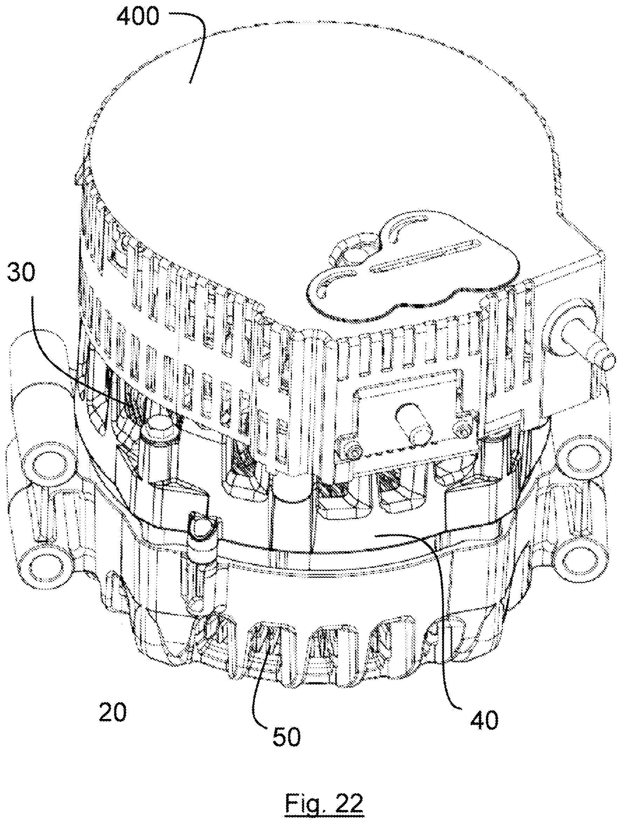

Dans ce mode de réalisation dans lequel la machine 1 (figure 22) est une machine de type alterno-démarreur fonctionnant sous une tension continue de 48 Volts, des potentiels de tension B+ et B- sont présents dans la machine 1 et correspondent respectivement au +48 V et au 0 V du 48 Volts. On notera ici que le B- (0 V) et le potentiel général de masse du véhicule (référencé M- à la figure 22) sont isolés électriquement dans la machine 1, masse générale qui est classiquement reliée à la borne électrique négative de la ou les batteries du véhicule ainsi qu'à la carrosserie de celui-ci et qui est également reliée dans la machine 1 au palier arrière 40 de celle-ci sur lequel est fixé l'ensemble électronique 10. Il est donc prévu une isolation électrique entre l'ensemble électronique dont la masse électrique est au B- et le palier arrière 40 relié au M-. Bien entendu, une connexion électrique peut être effectuée entre B- et M- dans le circuit électrique du véhicule, mais dans cette forme de réalisation celle-ci n'est pas faite dans la machine 1.

En référence notamment aux figures 8 et 9, le B+ est relié au circuit électrique du véhicule à travers une borne électrique 205 isolée du B-. Le B-est relié au circuit électrique du véhicule à travers une borne électrique 206 en liaison électrique avec les masses métalliques (dissipateurs notamment) du bloc de puissance 100 et du bloc de filtrage 200 et la masse du bloc de contrôle 300. Une languette de connexion électrique 207 est également montrée aux figures 8 et 9, cette languette 207 assure l'interconnexion du B+ entre le bloc de filtrage 200 et le bloc de puissance 100.

Le bloc de puissance 100 et le bloc de filtrage 200 comportent donc tout deux des traces conductrices de polarité positives et négatives reliées respectivement aux potentiels B+ et B-. Ces traces conductrices permettent le passage du courant à travers les composants électroniques des différents blocs 100, 200.

Au niveau du bloc de puissance 100, le premier dissipateur 101 est relié à la masse B-.

Comme on va le voir ci-après, grâce à la combinaison 500 (ou encore groupe ou sous-ensemble), montrée à la figure 1a, entre deux blocs de composants électroniques ayant des besoins de dissipation thermique différents, lesdits blocs étant le bloc de puissance 100 et le bloc de filtrage 200, et avec l'aide notamment de moyens d'isolation thermique et électrique et d'une unique pièce conductrice, on obtient à la fois une connexion électrique du B- entre le bloc de puissance 100 et le bloc de filtrage 200 et une isolation électrique de ce B- par rapport au M- du palier arrière 40, ainsi qu'une forte résistance thermique qui permet d'avoir un bon découplage thermique entre le bloc de puissance 100 et le bloc de filtrage 200.

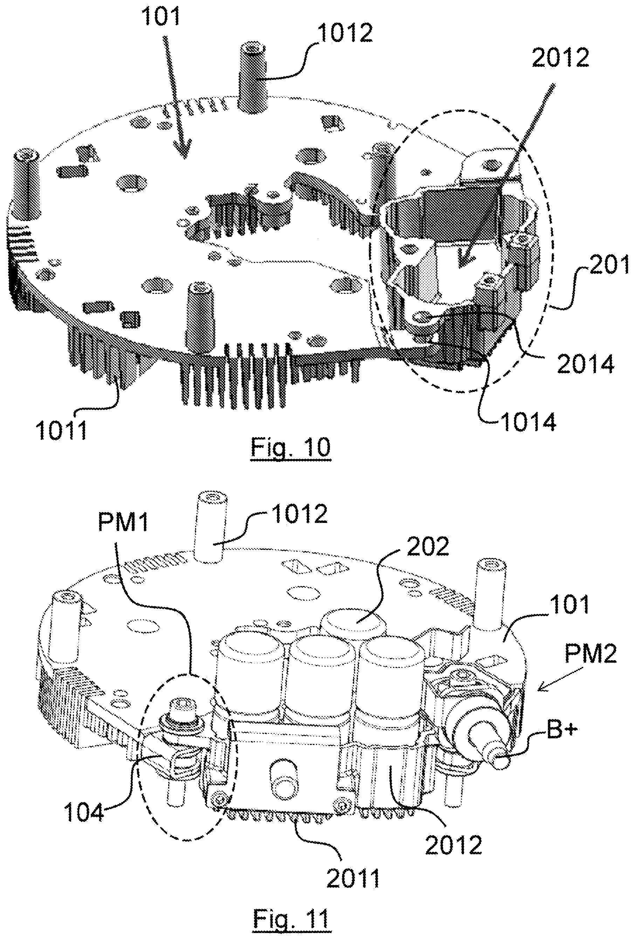

La combinaison 500 (ou encore groupe ou sous-ensemble) est illustrée à la figure 1a et les liaisons électrique, thermique et mécanique d'une telle combinaison 500 aux figures 11 à 13. Dans ces dernières figures, le bloc de puissance 100 n'a pas été représenté pour plus de clarté.

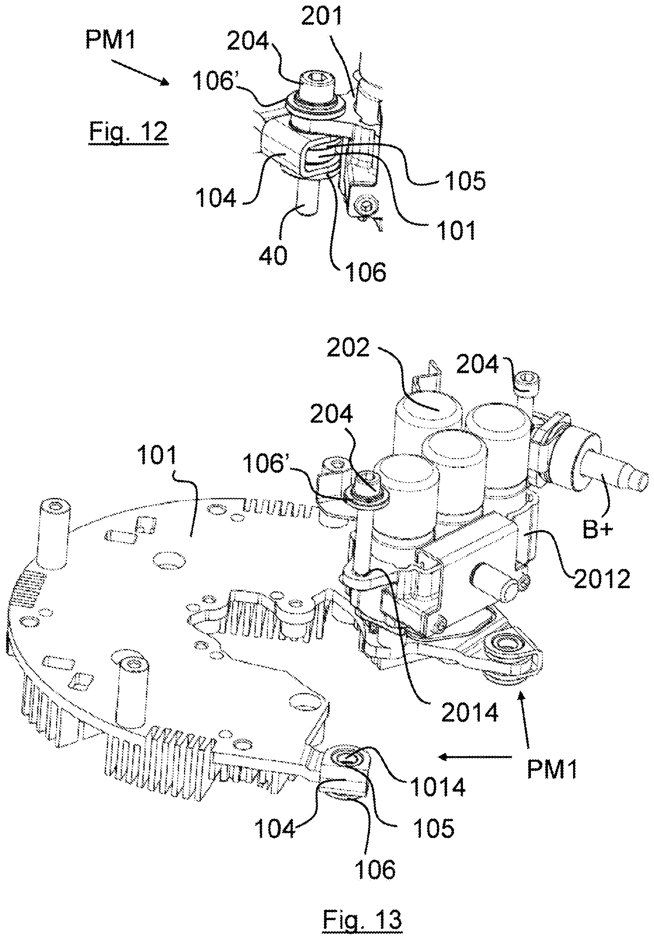

Ainsi, dans un mode de réalisation, l'assemblage électrique, thermique et mécanique de la combinaison 500, entre les blocs 100 et 200, et le montage de celle-ci au palier arrière 40 de la machine est assuré au niveau de deux points de montage PM1 et PM2 (Fig.11). En un premier point de montage PM1 montré notamment aux figures 12 et 13, cet assemblage est réalisé au moyen de :

- une vis de montage 204 ;
- une pièce électriquement conductrice 104 au potentiel B- et dont une première extrémité 1040 est en contact direct, par une face supérieure, avec une patte de montage du bloc de filtrage 200, sur une face inférieure de ladite patte du bloc 200, et une seconde extrémité 1041 est en contact direct, par une face supérieure, avec une patte de montage du bloc de puissance 100, sur une face inférieure de ladite patte du bloc 100, lesdites pattes de bloc 200 et de bloc 100 étant formées par des prolongements des dissipateurs 201 et 101, respectivement ;
- un isolant thermique 105 disposé entre :

    - ladite patte du bloc 100 qui est un prolongement du premier élément de refroidissement 101 qui est le premier dissipateur 101 muni d'une pluralité d'ailettes 1011 couplé audit bloc de puissance 100 ; et
    - une face inférieure de ladite pièce conductrice 104 ;

- un premier isolant électrique 106 disposé entre ladite pièce conductrice 104 et le palier arrière 40 de la machine électrique tournante ; et
- un second isolant électrique 106' disposé entre une tête de la vis de montage 204 et une face supérieure de ladite patte du bloc de filtrage 200.

Les fonctions de la pièce conductrice 104, de l'isolant thermique 105 et des isolants électriques 106 et 106' sont expliqués ci-dessous.

Afin de relier au même potentiel B- le bloc de puissance 100 et le bloc de filtrage 200, dans un premier mode de réalisation, la pièce conductrice 104 est utilisée tel qu'illustré sur les figures 11 à 13. Dans un mode de réalisation, ladite pièce conductrice est un bus barre ayant une forme générale en U.

On rappellera qu'un bus barre est une plaque formée de cuivre ou d'aluminium. Dans un mode de réalisation, il peut comporter un étamage complémentaire de sorte à empêcher l'oxydation du cuivre.

Ce bus barre 104 est disposé entre le dissipateur de bloc de puissance 101 et le dissipateur de bloc de filtrage 201 tel qu'illustré sur la figure 12, de sorte à créer une jonction entre les deux blocs 101 et 201. Il a ainsi une fonction de conducteur électrique et a une polarité négative B- de par son contact direct avec les pattes des bocs 100 et 200.

Tel qu'illustré sur les figures 10 à 13, le premier dissipateur 101 et le deuxième dissipateur 201 comportent respectivement des pattes de montage munies d'orifices de montage 1014, 2014 adaptés pour coopérer entre eux.

Comme illustré sur la figure 13 qui montre un éclaté de la figure 11, le deuxième dissipateur 201 comportent des orifices de montage 2014 qui se placent en regard des orifices de montage 1014 du premier dissipateur 101 décrits précédemment et les vis de montage 204 s'insèrent dans ces orifices de montage 1014, 2014 et se visent sur le palier arrière 40, assurant ainsi une fixation mécanique de l'ensemble électronique 10 sur le palier arrière 40 de la machine.

Ce mode de réalisation faisant appel au bus barre 104 et à l'isolant thermique 105 permet de minimiser les échanges thermiques par rapport à un autre mode dans lequel on mettrait les deux dissipateurs 101 et 201 en contact direct par leurs masses métalliques conductrices. En effet, dans le mode de réalisation décrit, la masse conductrice métallique du bus barre est dimensionnée pour obtenir la résistance électrique voulue pour la conduction électrique, ce qui conduit à une section et des surfaces de contact de faibles dimensions autorisant une minimisation de la conduction thermique entre les dissipateurs 101 et 201, sachant que la conduction thermique et électrique entre les dissipateurs 101 et 201 ne peut se faire qu'à travers le bus barre 104 du fait de la présence de l'isolant thermique (et électrique) 105. La résistance thermique entre les dissipateurs 101 et 201 est ainsi augmentée ce qui réduit les échanges thermiques et autorise un bon découplage thermique entre le boc de puissance 100 et le bloc de filtrage 200, les deux blocs 100 et 200 fonctionnant dans des plages de température différentes. On notera que du fait de la présence de condensateurs 202, le bloc de filtrage 200 ne doit pas atteindre des températures trop élevées (dans un exemple, de plus de 150°C) sinon, les condensateurs 202 pourraient subir des dégradations. Or le bloc de puissance 100 quant à lui peut dépasser les 150°C en raison de la présence des interrupteurs MOSFET qui libèrent beaucoup de chaleur. Il est ainsi nécessaire d'effectuer un découplage thermique entre le bloc de filtrage 200 et le bloc de puissance 100 tout en permettant le passage de courant entre les deux blocs.

Les isolants électriques 106 et 106' permettent l'isolation électrique entre les dissipateurs 101 et 201 au B- et le palier arrière 40 au M- de la machine électrique tournante 10, sachant que la vis de montage 204 se vise dans la masse métallique du palier arrière 40 de la machine. Les isolants électriques 106 et 106' empêchent tout contact entre la vis de montage 204 et les dissipateurs 101, 201 et bus barre 104.

Dans un exemple, l'isolant 105 est une rondelle formée dans un plastique de faible conductivité thermique et les isolants 106 et 106' sont des rondelles formées dans un plastique de faible conductivité électrique. Ces rondelles sont illustrées sur la figure 12 qui est un zoom de la partie pointillée sur la figure 11.

On notera que les orifices 1014, 2014 des pattes de montage devront avoir un diamètre suffisamment grand par rapport à celui de la vis de montage 204 pour éviter tout contact de celle-ci avec les parois internes des orifices 1014, 2014 et permettre l'insertion dans l'espace entre les bords circulaires / parois internes des orifices 1014, 2014 et la surface de tige de la vis de montage 204 d'un collerette de rebord (non représentée) des rondelles isolantes 106, 106', cette collerette de rebord garantissant l'impossibilité d'un tel contact. Ces moyens permettent d'obtenir le montage d'isolation électrique souhaité entre les masses métalliques des dissipateurs 101/201 et le palier arrière de la machine.

Un second point de montage PM2, au niveau de la borne électrique isolée 205, est utilisé pour l'assemblage électrique, thermique et mécanique de la combinaison 500, entre les blocs 100 et 200, et le montage de celle-ci au palier arrière 40 de la machine. Les moyens utilisés étant sensiblement les mêmes que ceux utilisés au premier point de montage PM1, ceux-ci ne seront pas détaillés ici.

Bloc de contrôle

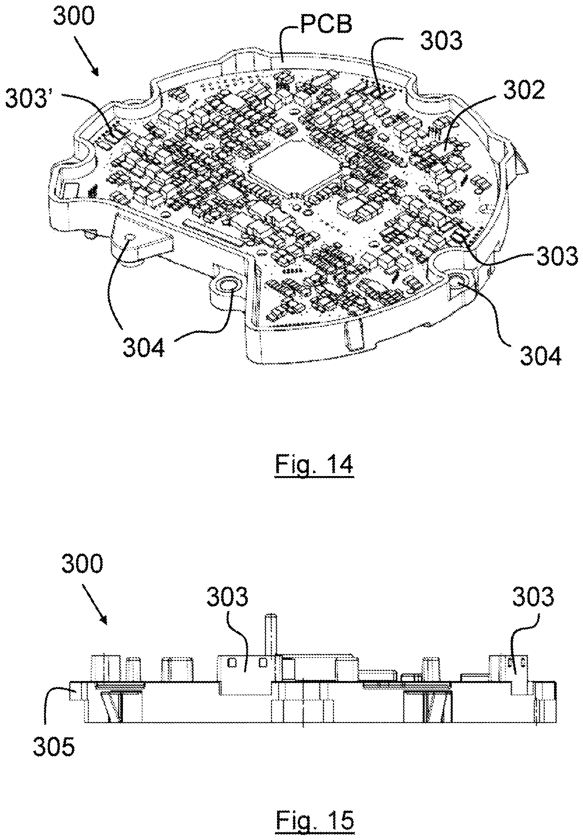

Le bloc de contrôle est illustré sur les figures 14 à 16.

Comme illustré sur la vue en perspective de la figure 14, le bloc de contrôle 300 comporte des composants 302 pour contrôler la machine électrique tournante et notamment le réglage du de la machine en contrôlant les modules de puissance 1001 du bloc de puissance 100. Les composants 302 étant connus de l'homme du métier, ils ne sont pas décrits dans la suite de la description.

Le bloc de contrôle est composé d'une carte à circuit imprimée PCB (appelé en anglais « Printed Circuit Board ») sur laquelle sont montés les composants de contrôle 302.

Le bloc de contrôle 300 est séparé thermiquement du bloc de puissance 100. Ainsi, la fonction contrôle des modules de puissance n'est pas située dans ces derniers. A cet effet, dans un mode de réalisation, le bloc de contrôle 300 est disposé sur un premier plan P1 parallèle à un deuxième plan P2 sur lequel est monté le bloc de puissance 100 de sorte à permettre un passage d'un flux d'air de refroidissement F2 entre les deux blocs 100, 300. Ainsi, en créant un espace entre les deux blocs 100 et 300, cela permet d'amener de l'air entre les deux blocs. Le tout est ainsi refroidi tout en créant un découplage thermique entre les deux blocs. La création de ce flux d'air sera expliquée dans la suite de la description.

Dans un exemple, le bloc de contrôle 300 est monté en mezzanine du bloc de puissance 100 au moyen d'orifices de montage 304 couplés aux plots de montage 1013 du premier dissipateur 101 qui servent d'entretoises comme vu précédemment.

Afin de communiquer entre eux, le bloc de puissance 100 et le bloc de contrôle 300 sont reliés entre eux au moyens de pins d'interconnexion respectivement 103, 103' tels qu'illustrés sur les figures 2, 3, 4. Ces pins d'interconnexion 103-103' s'insèrent respectivement dans des emplacements prévus 303-303' du bloc de contrôle, tel qu'illustré à la figure 14. La figure 15 est une vue de profil du bloc de contrôle 300.

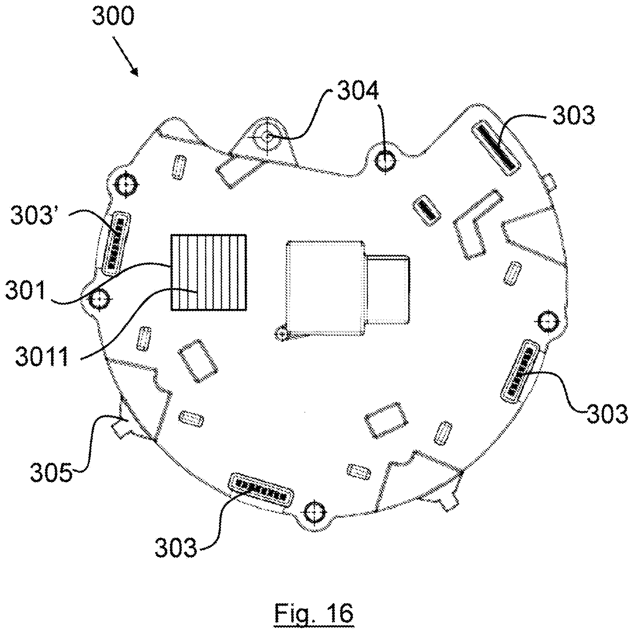

La figure 16 montre le bloc de contrôle 300 en vue de dessous. On retrouve les emplacements 303-303' pour insérer les pins d'interconnexion 103-103' décrits précédemment, ainsi que les orifices de montage 304 décrits précédemment.

Chaque pin ayant une section faible, on minimise la possibilité d'échange thermique entre les deux blocs.

On notera que les modules de puissance 1001 comportent un premier ensemble de pins d'interconnexion 103, qui sont des pins de signal.

Par ailleurs, le module d'excitation 1002 comporte des pins d'interconnexion 103' qui permettent d'envoyer des signaux de mesure et des signaux de commande. Ainsi, ils permettent de commander le courant d'excitation rotorique et de le contrôler, d'envoyer des signaux capteurs pour contrôler la position du rotor, de remonter la température de la machine etc.

On notera par ailleurs que lors de leur fonctionnement, certains composants du PCB s'échauffent et font monter la température de la plaque PCB. Aussi, afin de refroidir cette plaque PCB, dans un mode de réalisation, le dispositif de refroidissement 10' comprend un troisième élément de refroidissement qui est un troisième dissipateur 301 (appelé également dissipateur de bloc de contrôle) muni d'une pluralité d'ailettes 3011 couplé au bloc de contrôle 300 tel qu'illustré sur la vue de dessous de la figure 16.

Ainsi, en implantant un dissipateur dans le boîtier PCB, et plus précisément sur la face inférieure du PCB, il est possible d'utiliser également le même flux d'air de refroidissement F2 qui permet le découplage thermique entre le bloc de contrôle 300 et le bloc de puissance 100, pour extraire les calories apportées par les composants du PCB.

Dans des exemples, le troisième dissipateur 301 est couplé à des composants du bloc de contrôle 300 au moyen d'une résine, d'une lame métallique, d'un joint de remplissage (appelé en anglais « gap filaire » ou d'un tampon de remplissage (appelé en anglais « gap pad »).

Capot de protection

Comme on va le voir ci-après, les flux d'air de refroidissement adaptés à chaque bloc de dissipation thermique différent sont générés et orientés sur les différents blocs au moyen du capot de protection. Une partie de ces flux d'air va donc lécher les ailettes des différents dissipateurs couplés aux différents blocs et ainsi optimiser le refroidissement desdits blocs, lesdites ailettes augmentant la surface de dissipation des composants qui chauffent.

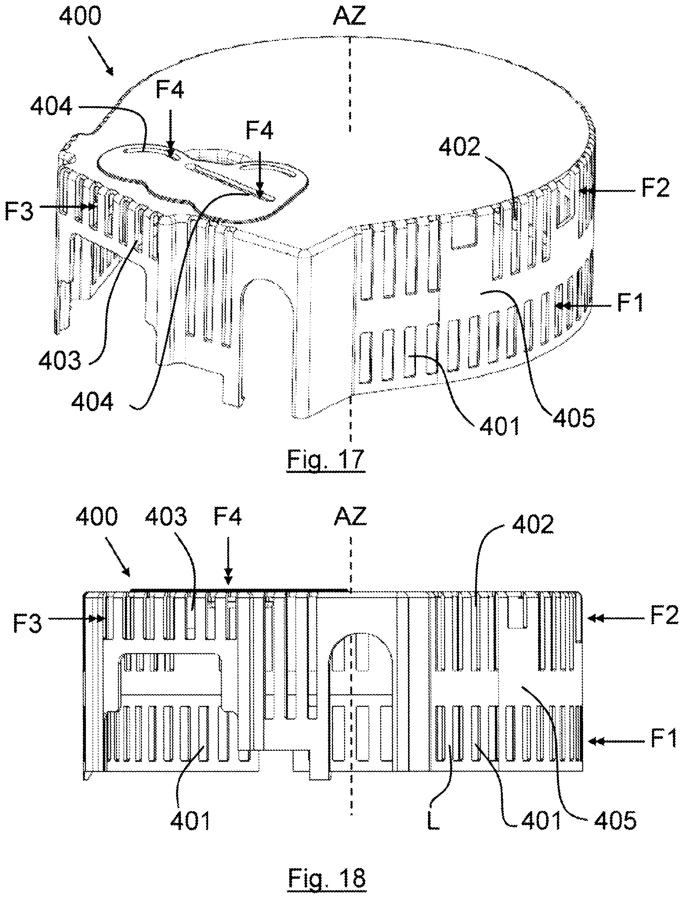

Le capot de protection 400 est illustré sur les figures 17 à 19.

Comme illustré sur les figures 17 et 18, le capot de protection 400 comporte des ouvertures qui sont réparties en :

- un premier ensemble d'ouvertures 401 adaptées pour être positionnées en regard des ailettes du premier dissipateur 101 ;
- un deuxième ensemble d'ouvertures 402 adaptées pour être positionnées en regard du bloc de contrôle 300 ; les deux ensembles d'ouvertures 401, 402 étant séparés par un muret de séparation 405 de sorte à créer un premier flux d'air de refroidissement radial F1 pour ledit bloc de puissance 100 et un deuxième flux d'air de refroidissement radial F2 pour ledit bloc de contrôle 300 ; et
- un troisième ensemble d'ouvertures 403 adapté pour être positionné en regard des ailettes du deuxième dissipateur 201 de sorte à créer un troisième flux d'air de refroidissement F3 pour ledit bloc de filtrage 200.

Le ventilateur 40 de la machine électrique aspire de l'air pour refroidir le stator de ladite machine. Cet air est aspiré latéralement via les ouvertures 401, 402, 403 du capot de protection et s'écoule ainsi vers et à travers lesdites ouvertures. A partir de cet air aspiré, du fait de la présence des trois types d'ouvertures 401, 402 et 403 et du muret de séparation 405, trois flux d'air différents sont respectivement créés F1, F2 et F3.

Dans ce mode de réalisation, le muret de séparation 405 qui sert de séparation entre le premier ensemble d'ouvertures 401 et le deuxième ensemble d'ouvertures 402 est constitué par la matière du capot 400.

• Premier ensemble d'ouvertures 401

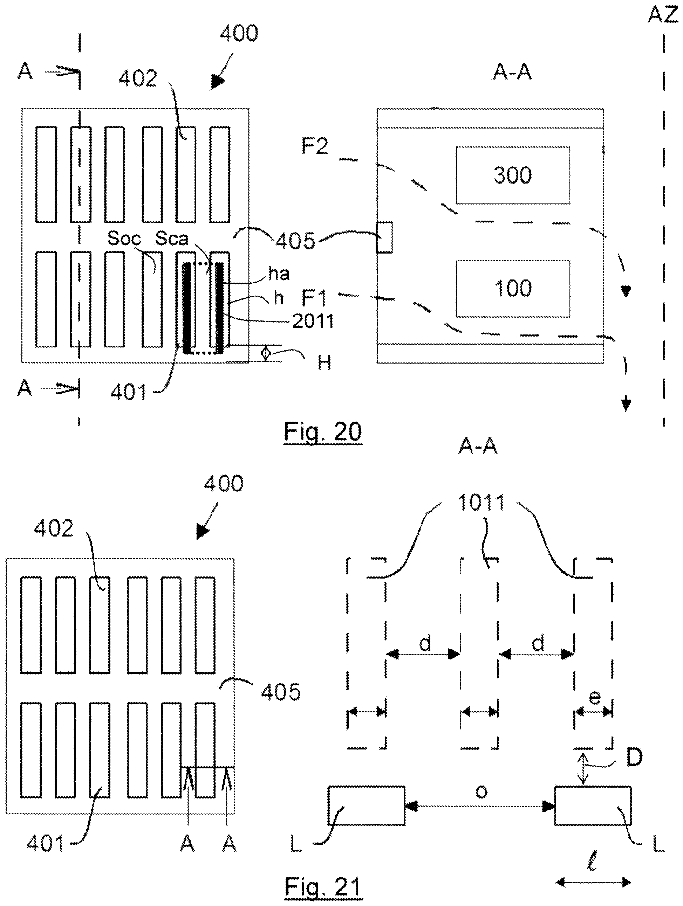

Le premier ensemble d'ouvertures 401 permet de générer le premier flux d'air F1. Comme ce premier flux d'air F1 est aspiré par le ventilateur vers le bas, il se retrouve à lécher la surface inférieure du bloc de puissance 100 (via le premier dissipateur 101). Comme on peut le voir sur le schéma explicatif de la figure 20, le premier flux d'air F1 va s'écouler radialement à travers le premier ensemble d'ouvertures 401 et lécher les éléments dissipateurs, à savoir les ailettes 2011 du premier dissipateur 101 sur toute la longueur, avant de s'évacuer axialement vers la machine électrique 1, à savoir le long de l'axe AZ du rotor. Ainsi, le bloc de puissance 100 est refroidi à travers le refroidissement du premier dissipateur 101 via les ailettes.

• Deuxième ensemble d'ouvertures 401

Le deuxième ensemble d'ouvertures 402 permet de générer le deuxième flux d'air F2. Comme on peut le voir sur le schéma explicatif de la figure 20, ce deuxième flux d'air F2 s'écoule à travers le deuxième ensemble d'ouvertures 402 et radialement sous la surface inférieure du bloc de contrôle 300, avant de s'évacuer axialement le long de l'axe AZ. Le bloc de contrôle 300 est ainsi refroidi.

Un bon découplage thermique entre les deux blocs 100 et 300 est obtenu par cette séparation du flux d'air de refroidissement en un premier flux F1 et un deuxième flux F2 ayant des chemins d'écoulement différents.

On notera que dans le mode de réalisation où le troisième dissipateur 301 est présent, le refroidissement des composants du bloc de contrôle 300 par le flux d'air F2 est optimisé car ledit flux F2 va lécher les ailettes 3011 dudit dissipateur 301. L'extraction des calories apportées par certains des composants du boîtier PCB qui s'échauffent est ainsi améliorée.

Dans un mode de réalisation, les ouvertures du premier ensemble d'ouvertures 401 et du deuxième ensemble d'ouvertures 402 du capot de protection 400 sont latérales et disposées dans la même direction que les ailettes du premier dissipateur 101. Ainsi, les ouvertures du capot de protection étant disposées dans le même sens que les ailettes du premier dissipateur 101, à savoir ici à la verticale, le flux d'air qui passe par les ouvertures et qui vient lécher les ailettes est plus important que si les ouvertures étaient dans une direction différente.

Ainsi, en réalisant deux ensembles d'ouvertures 401, 402 sur la hauteur du capot de protection 400, au lieu d'un seul ensemble, il est possible de mieux canaliser le flux d'air entrant. De plus, le positionnement du muret 405 entre les deux ensembles d'ouvertures verticales 401, 402 permet d'obtenir deux flux d'air pour refroidir respectivement le bloc de puissance 100 et le bloc de filtrage 200.

Pour optimiser le couplage ouvertures capot/ailettes du premier dissipateur 101, il faut que ces ouvertures soient correctement positionnées vis-à-vis des ailettes du premier dissipateur 101.

En référence plus particulièrement aux figures 20 et 21, l'arrangement des ailettes du premier dissipateur 101, du capot de protection 400 et des ouvertures du premier ensemble et /ou du deuxième ensemble d'ouvertures 401, 402 est effectué de manière à satisfaire les relations suivantes :

$$h \geq 0{,}5 \, . \, ha \qquad\qquad (1)$$

$$H < 0{,}5 \, . \, ha \quad , \, et \qquad\qquad (2)$$

$$D \geq 0{,}5 \, . \, (d^2 - ((o\text{-}e)/2)^2)^{1/2} \, . \qquad\qquad (3)$$

Sachant que h est la hauteur de l'ouverture capot, ha est la hauteur de l'ailette, H est la distance entre le bas du capot et le bas de l'ouverture, D est la distance entre le bord intérieur du capot et le bord d'attaque de l'ailette, d est un espace inter-ailettes séparant deux ailettes adjacentes, o est la largeur d'une ouverture capot et e est l'épaisseur d'une ailette.

Les relations (1) à (3) ci-dessus ont été déterminées par l'entité inventive au moyen d'essais visant à déterminer un arrangement offrant un optimum de refroidissement. La relation (1) en particulier permet de garantir que la section d'ouverture capot Soc est suffisamment supérieure à la section du canal inter-ailettes Sca.

• Troisième ensemble d'ouvertures 403

Le troisième ensemble d'ouvertures 403 permet de générer le troisième flux d'air F3. Ce dernier va s'écouler radialement à travers le troisième ensemble d'ouvertures 403 et lécher les éléments dissipateurs, à savoir les ailettes du deuxième dissipateur 201 sur toute la longueur, avant de s'évacuer axialement vers la machine électrique, à savoir le long de l'axe AZ du rotor.

Dans un mode de réalisation, les ouvertures du troisième ensemble d'ouvertures 403 sont latérales et sont disposées dans la même direction que les ailettes du deuxième dissipateur 201.

Ainsi, ces ouvertures du capot de protection étant disposées dans le même sens que les ailettes du deuxième dissipateur 201, à savoir ici à la verticale, le flux d'air qui passe par les ouvertures et qui vient lécher les ailettes est plus important que si les ouvertures étaient dans une direction différente. Cela permet donc d'obtenir une grande surface d'échange avec le troisième flux d'air F3 et donc de refroidir d'autant plus le bloc de filtrage 200 et en particulier les condensateurs 202.

• Quatrième ensemble d'ouvertures 404

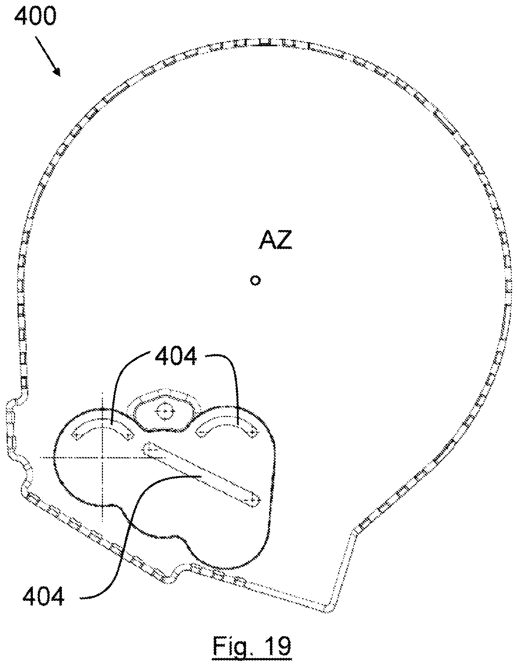

Dans un mode de réalisation, le capot de protection 400 comporte en outre un quatrième ensemble d'ouvertures 404 situées sur le dessus dudit capot 400 (tel qu'illustré sur les figures 17 ou 19) adapté pour être positionné au dessus des condensateurs 202 du bloc de filtrage 200 de sorte à créer un quatrième flux d'air de refroidissement F4 pour le bloc de filtrage 200.

Tel qu'illustré sur les figures 17 et 18, ce quatrième flux F4 va s'écouler axialement à travers le quatrième ensemble d'ouvertures 404, à savoir le parallèlement à l'axe AZ du rotor, et lécher les condensateurs 202, mais également les éléments dissipateurs, à savoir les ailettes 2011 du deuxième dissipateur 201, avant de s'évacuer vers la machine électrique.

On créé ainsi un flux d'air axial refroidissant également les condensateurs de filtrage 202.

Ainsi, les ailettes du deuxième dissipateur 202 reçoivent un flux d'air radial F3 et un flux d'air axial F4, ce qui permet d'augmenter la surface d'échange avec l'air et donc d'obtenir un flux d'air optimal (composé de deux flux d'air) sur les ailettes. Grâce à cette optimisation d'échange thermique, les condensateurs sont ainsi bien refroidis.

On notera qu'une autre fonction du capot de protection 405 est de protéger l'ensemble électronique contre les agressions mécaniques telles que l'intrusion d'une vis ou d'un outil mécanique par exemple etc. Aussi, les ouvertures 401, 402,403 et également 404 doivent être dimensionnées pour éviter de telles agressions mécaniques et respecter une largeur maximale l déterminée en fonction de la protection souhaitée contre lesdites agressions. La valeur l est

ainsi dictée par le degré de protection souhaitée pour l'alterno-démarreur contre la pénétration de corps é étrangers, notamment solides (couramment appelé protection IP).

Ainsi, l'ensemble électronique 10 décrit précédemment permet de faire fonctionner l'alterno-démarreur 1. Ce dernier comporte, tel qu'illustré sur la figure 22 :

- un rotor (non apparent dans la figure 22);
- un stator 30 couplé audit rotor et comportant une pluralité de phases ;
- un ensemble électronique 10 selon l'une quelconque des revendications précédentes, le bloc de puissance 100 dudit ensemble électronique 10 étant adapté pour être connecté aux phases dudit stator 30 ;
- un palier arrière 40 supportant ledit stator 20 ; et
- un ventilateur 50 situé à proximité du palier arrière 40.

Ainsi, la présente invention s'applique à tout type de machines électriques tournantes polyphasées réversibles, tels que des alterno-démarreurs, entraînées par exemple par courroie ou intégrée, et notamment pour des applications hybrides.

Ainsi, dans un autre exemple d'application l'alterno-démarreur est « full-hybrid » et permet d'entraîner le véhicule automobile au moyen du moteur électrique seul (en général au démarrage), ou du moteur thermique seul (en général lorsque la vitesse augmente), ou des deux moteurs en même temps (par exemple pour obtenir une plus forte accélération). La batterie qui alimente le moteur électrique récupère de l'énergie par freinage récupératif.

Ainsi, l'invention décrite présente notamment les avantages suivants :

- elle permet un découplage thermique entre le bloc de contrôle et le bloc de puissance grâce à :
- leur assemblage mécanique : les deux blocs sont disposés sur deux plans parallèles avec un espace laissant passer un flux d'air, et
- leur assemblage électrique : les deux blocs sont connectés via les pins d'interconnexion qui minimisent la possibilité d'échange thermique entre les deux blocs, la surface d'échange thermique étant très réduite ;
- au deuxième flux d'air passant entre le bloc de contrôle et le bloc de puissance ;
- elle permet un découplage thermique entre le bloc de puissance et le bloc de filtrage grâce à :
- l'isolement thermique du deuxième dissipateur et du premier dissipateur via les rondelles isolantes ;
- leur assemblage électrique : les deux blocs sont connectés via un unique bus barre qui minimise la possibilité d'échange thermique entre les deux blocs, la masse conductrice étant réduite ;
- elle permet une optimisation du refroidissement des composants de l'ensemble électrique grâce à :
- l'architecture en blocs fonctionnels séparés, bloc de puissance, bloc de filtrage, bloc de contrôle, les blocs ayant des températures de fonctionnement différents (moyennes et maximales) ainsi que des besoins de dissipation différents ;
- la création de flux d'air dédiés à chaque bloc fonctionnel via l'architecture du capot de protection du dispositif de refroidissement :

  - la présence du muret de séparation entre deux ensembles d'ouvertures ;
  - les ouvertures pour orienter l'entrée d'air dans l'ensemble électronique ;
  - la forme et le positionnement de ces ouvertures par rapport aux ailettes de refroidissement des premier et deuxième dissipateurs ;

- le couplage des éléments de refroidissement du dispositif de refroidissement, à savoir des différents dissipateurs, avec les différents blocs fonctionnels, les ailettes desdits dissipateurs permettant d'augmenter la surface d'échange avec l'air pour évacuer les calories ;
- le passage d'un flux d'air radial et d'un flux d'air axial pour éviter une surchauffe des condensateurs et ainsi éviter qu'ils ne s'abîment ;
- la résine qui permet une bonne évacuation des calories des condensateurs vers le deuxième dissipateur ;
- la présence d'ouvertures dans le premier dissipateur pour refroidir les bus barres.

## Revendications

1. Ensemble électronique (10) pour machine électrique tournante (1) pour véhicule automobile selon lequel ledit ensemble électronique comporte :

   - des blocs (100, 200, 300) de composants électroniques, les blocs ayant des besoins de dissipation thermique différents, les blocs étant :

- un bloc de puissance (100) ;
- un bloc de filtrage (200) ;
- un bloc de contrôle (300) ;

- un dispositif de refroidissement (10') desdits blocs (100, 200, 300), ledit dispositif de refroidissement (10') comportant :

- un capot de protection (400) adapté pour recouvrir les blocs de puissance, de filtrage et de contrôle (100, 200, 300), ledit capot de protection comportant des ouvertures (401, 402, 403, 404) adaptées pour générer des flux d'air de refroidissement (F1, F2, F3, F4) différents pour les besoins de dissipation thermique de chacun des blocs de puissance (100), de contrôle (300) et de filtrage (200) ; et
- des éléments de refroidissement (101, 201, 301) coopérant thermiquement avec les ouvertures (401, 402, 403, 404) dudit capot de protection (400);

- un premier élément de refroidissement est un premier dissipateur (101) muni d'une pluralité d'ailettes (1011) couplé audit bloc de puissance (100) ;
- un deuxième élément de refroidissement est un deuxième dissipateur (201) muni d'une pluralité d'ailettes (2011) couplé à des condensateurs (202) dudit bloc de filtrage (200) ;
- le bloc de contrôle (300) est disposé sur un premier plan (P1) parallèle à un deuxième plan (P2) sur lequel est monté le bloc de puissance (100) de sorte à permettre un passage d'un flux d'air de refroidissement (F2) entre les deux blocs (100, 300) ;
- les ouvertures du capot de protection (400) sont réparties en :

- un premier ensemble d'ouvertures (401) adaptées pour être positionnées en regard des ailettes du premier dissipateur (101) ;
- un deuxième ensemble d'ouvertures (402) adaptées pour être positionnées en regard du bloc de contrôle (300) ;
les deux ensembles d'ouvertures (401, 402) étant séparés par un muret de séparation (405) de sorte à créer un premier flux d'air de refroidissement radial (F1) pour ledit bloc de puissance (100) et un deuxième flux d'air de refroidissement radial (F2) pour ledit bloc de contrôle (300) ; et
- un troisième ensemble d'ouvertures (403) adaptées pour être positionnées en regard des ailettes du deuxième dissipateur (201) de sorte à créer un troisième flux d'air de refroidissement radial (F3) pour ledit bloc de filtrage (200).

2. Ensemble électronique (10) selon la revendication 1, selon lequel les ailettes du premier dissipateur (101) sont disposées par groupe d'ailettes parallèles et les groupes sont disposés de manière à autoriser une circulation radiale d'un flux d'air de refroidissement sous le bloc de puissance (100).

3. Ensemble électronique (10) selon l'une quelconque des revendications précédentes, selon lequel le bloc de puissance (100) et le bloc de filtrage (200) sont reliés électriquement au moyen d'une pièce conductrice (104) de polarité négative.

4. Ensemble électronique (10) selon la revendication précédente, selon lequel le premier dissipateur (101) et le deuxième dissipateur (201) comportent respectivement des orifices de montage (1014-2014) adaptés pour coopérer entre eux.

5. Ensemble électronique (10) selon la revendication 1 ou 2, selon lequel l'assemblage entre le bloc de puissance (100) et le bloc de filtrage (200) fait appel à une vis de montage (204), une pièce conductrice (104), un isolant thermique (105) disposé entre une patte de montage (1014) du premier dissipateur (101) et une face inférieure de ladite pièce conductrice (104), un premier isolant électrique (106) disposé entre ladite pièce conductrice (104) et un palier arrière (40) de la machine électrique tournante, et un second isolant électrique (106') disposé entre une tête de la vis de montage (204) et une face supérieure d'une patte de montage (2014) du deuxième dissipateur (201).

6. Ensemble électronique (10) selon la revendication 1, selon lequel un troisième élément de refroidissement est un troisième dissipateur (301) muni d'une pluralité d'ailettes (3011) couplé au bloc de contrôle (300).

**7.** Ensemble électronique (10) selon la revendication précédente, selon lequel le troisième dissipateur (301) est couplé à des composants du bloc de contrôle (300) au moyen d'une résine, d'une lame métallique, d'un joint de remplissage ou d'un tampon de remplissage.

**8.** Ensemble électronique (10) selon l'une quelconque des revendications précédentes, selon lequel les ouvertures du premier ensemble d'ouvertures (401), du deuxième ensemble d'ouvertures (402) et du troisième ensemble d'ouvertures (403) du capot de protection (400) sont latérales, et les ouvertures du premier ensemble d'ouvertures (401) et du deuxième ensemble d'ouvertures (402) sont disposées en correspondance avec les ailettes du premier dissipateur (101).

**9.** Ensemble électronique (10) selon l'une quelconque des revendications précédentes, selon lequel l'arrangement des ailettes du premier dissipateur (101), du capot de protection (400) et des ouvertures du premier ensemble (401) est effectué de manière à satisfaire les relations suivantes :

$$h \geq 0{,}5 \cdot ha$$

$$H < 0{,}5 \cdot ha \ ,$$

et

$$D \geq 0{,}5 \cdot (d^2 - ((o\text{-}e)/2)^2)^{1/2},$$

sachant que h est la hauteur d'une ouverture du capot de protection (400), ha est la hauteur d'une ailette du premier dissipateur (101), H est la distance entre le bas du capot de protection (400) et le bas d'une ouverture, D est la distance entre le bord intérieur du capot de protection (400) et le bord d'attaque d'une ailette du premier dissipateur (101), d est un espace inter-ailettes séparant deux ailettes adjacentes du premier dissipateur (101), o est la largeur d'une ouverture et e est l'épaisseur d'une ailette.

**10.** Ensemble électronique (10) selon l'une quelconque des revendications précédentes, selon lequel le capot de protection (400) comporte en outre un quatrième ensemble d'ouvertures (404) situées sur le dessus dudit capot (400) adapté pour être positionné au dessus des condensateurs (202) du bloc de filtrage (200) de sorte à créer un quatrième flux d'air de refroidissement axial (F4) pour le bloc de filtrage (200).

**11.** Machine électrique tournante (1) comportant :

- un rotor ;
- un stator (30) couplé audit rotor et comportant une pluralité de phases ;
- un ensemble électronique (10) selon l'une quelconque des revendications précédentes, le bloc de puissance (100) dudit ensemble électronique (10) étant adapté pour être connecté aux phases dudit stator (30) ;
- un palier arrière (40) supportant ledit stator (30) ; et
- un ventilateur (50) situé à proximité du palier arrière (40).

**12.** Machine électrique tournante, selon la revendication précédente, selon laquelle ladite machine électrique tournante (1) est un alterno-démarreur.

**13.** Machine électrique tournante, selon la revendication précédente, selon laquelle ledit alterno-démarreur comprend une fonction de freinage récupératif et une fonction d'assistance à l'accélération.

**Patentansprüche**

**1.** Elektronische Anordnung (10) für eine drehende elektrische Maschine (1) für ein Kraftfahrzeug, wobei die elektronische Anordnung Folgendes aufweist:

- Blöcke (100, 200, 300) elektronischer Bauelemente, wobei die Blöcke unterschiedliche Wärmeableitungsbedarfe aufweisen, wobei die Blöcke folgende sind:
- ein Leistungsblock (100);
- ein Filterungsblock (200);
- ein Steuerblock (300);
- eine Vorrichtung zur Kühlung (10') der Blöcke (100, 200, 300), wobei die Kühlvorrichtung (10') Folgendes aufweist:

- eine Schutzabdeckung (400), die geeignet ist, die Leistungs-, Filterungs- und Steuerblöcke (100, 200, 300) abzudecken, wobei die Schutzabdeckung Öffnungen (401, 402, 403, 404) aufweist, die geeignet sind, unterschiedliche Kühlluftströme (F1, F2, F3, F4) für die Wärmeableitungsbedarfe jedes der Leistungs- (100), Steuer- (300) und Filterungsblöcke (200) zu erzeugen; und
- Kühlelemente (101, 201, 301), die mit den Öffnungen (401, 402, 403, 404) der Schutzabdeckung (400) thermisch zusammenwirken;
- wobei ein erstes Kühlelement ein erster Kühlkörper (101) mit einer Mehrzahl von Rippen (1011) ist, der an den Leistungsblock (100) gekoppelt ist;
- ein zweites Kühlelement ein zweiter Kühlkörper (201) mit einer Mehrzahl von Rippen (2011) ist, der an Kondensatoren (202) des Filterungsblocks (200) gekoppelt ist;
- der Steuerblock (300) auf einer ersten Ebene (P1) parallel zu einer zweiten Ebene (P2) angeordnet ist, auf der der Leistungsblock (100) angebracht ist, um einen Durchtritt eines Kühlluftstoms (F2) zwischen den zwei Blöcken (100, 300) zu gestatten;
- die Öffnungen der Schutzabdeckung (400) in Folgendes aufgeteilt sind:

- eine erste Anordnung von Öffnungen (401), die geeignet sind, gegenüber den Rippen des ersten Kühlkörpers (101) positioniert zu sein;
- eine zweite Anordnung von Öffnungen (402), die geeignet sind, gegenüber dem Steuerblock (300) positioniert zu sein;
wobei die zwei Anordnungen von Öffnungen (401, 402) durch eine Trennwand (405) so getrennt sind, dass ein erster radialer Kühlluftstrom (F1) für den Leistungsblock (100) und ein zweiter radialer Kühlluftstrom (F2) für den Steuerblock (300) erzeugt wird; und
- eine dritte Anordnung von Öffnungen (403), die geeignet sind, gegenüber den Rippen des zweiten Kühlkörpers (201) so positioniert zu sein, dass ein dritter radialer Kühlluftstrom (F3) für den Filterungsblock (200) erzeugt wird.

2. Elektronische Anordnung (10) nach Anspruch 1, wobei die Rippen des ersten Kühlkörpers (101) pro Gruppe paralleler Rippen angeordnet sind und die Gruppen so angeordnet sind, dass eine radiale Durchströmung eines Kühlluftstroms unter dem Leistungsblock (100) ermöglicht wird.

3. Elektronische Anordnung (10) nach einem der vorhergehenden Ansprüche, wobei der Leistungsblock (100) und der Filterungsblock (200) mittels eines leitendes Teils (104) negativer Polarität elektrisch verbunden sind.

4. Elektronische Anordnung (10) nach dem vorhergehenden Anspruch, wobei der erste Kühlkörper (101) und der zweite Kühlkörper (201) jeweils Montageöffnungen (1014 - 2014) aufweisen, die geeignet sind, miteinander zusammenzuwirken.

5. Elektronische Anordnung (10) nach Anspruch 1 oder 2, wobei der Zusammenbau zwischen dem Leistungsblock (100) und dem Filterungsblock (200) eine Montageschraube (204), ein leitendes Teil (104), einen Wärmeisolator (105), der zwischen einem Montagefuß (1014) des ersten Kühlkörpers (101) und einer Unterseite des leitenden Teils (104) angeordnet ist, einen ersten elektrischen Isolator (106), der zwischen dem leitenden Teil (104) und einem hinteren Lager (40) der drehenden elektrischen Maschine angeordnet ist, und einen zweiten elektrischen Isolator (106'), der zwischen einem Kopf der Montageschraube (204) und einer Oberseite eines Montagefußes (2014) des zweiten Kühlkörpers (201) angeordnet ist, erfordert.

6. Elektronische Anordnung (10) nach Anspruch 1, wobei ein drittes Kühlelement ein dritter Kühlkörper (301) mit einer Mehrzahl von Rippen (3011) ist, der an den Steuerblock (300) gekoppelt ist.

7. Elektronische Anordnung (10) nach dem vorhergehenden Anspruch, wobei der dritte Kühlkörper (301) mittels eines Harzes, eines Metallblatts, einer Füllmasse oder eines Gap-Pads an Bauelemente des Steuerblocks (300) gekoppelt ist.

8. Elektronische Anordnung (10) nach einem der vorhergehenden Ansprüche, wobei die Öffnungen der ersten Anordnung von Öffnungen (401), der zweiten Anordnung von Öffnungen (402) und der dritten Anordnung von Öffnungen (403) der Schutzabdeckung (400) seitlich verlaufen und die Öffnungen der ersten Anordnung von Öffnungen (401) und der zweiten Anordnung von Öffnungen (402) in Übereinstimmung mit den Rippen des ersten Kühlkörpers (101) angeordnet sind.

9. Elektronische Anordnung (10) nach einem der vorhergehenden Ansprüche, wobei die Anordnung der Rippen des ersten Kühlkörpers (101), der Schutzabdeckung (400) und der Öffnungen der ersten Anordnung (401) so ausgeführt ist, dass die folgenden Beziehungen erfüllt sind:

$$h \geq 0{,}5 \cdot ha$$

$$H < 0{,}5 \cdot ha,$$

und

$$D \geq 0{,}5 \cdot (d^2 - ((o-e)/2)^2)^{1/2},$$

wobei h die Höhe einer Öffnung der Schutzabdeckung (400) ist, ha die Höhe einer Rippe des ersten Kühlkörpers (101) ist, H der Abstand zwischen dem unteren Bereich der Schutzabdeckung (400) und dem unteren Bereich einer Öffnung ist, D der Abstand zwischen dem Innenrand der Schutzabdeckung (400) und dem vorderen Rand einer Rippe des ersten Kühlkörpers (101) ist, d ein Rippenzwischenraum ist, der zwei Rippen trennt, die dem ersten Kühlkörper (101) benachbart sind, o die Breite einer Öffnung und e die Dicke einer Rippe ist.

10. Elektronische Anordnung (10) nach einem der vorhergehenden Ansprüche, wobei die Schutzabdeckung (400) ferner eine vierte Anordnung von Öffnungen (404) aufweist, die sich auf der Oberseite der Abdeckung (400) befinden, die geeignet ist, über den Kondensatoren (202) des Filterungsblocks (200) so positioniert zu sein, dass ein vierter axialer Kühlluftstrom (F4) für den Filterungsblock (200) erzeugt wird.

11. Drehende elektrische Maschine (1) aufweisend:

   - einen Rotor;
   - einen Stator (30), der an den Rotor gekoppelt ist und eine Mehrzahl von Phasen aufweist;
   - eine elektronische Anordnung (10) nach einem der vorhergehenden Ansprüche, wobei der Leistungsblock (100) der elektronischen Anordnung (10) geeignet ist, an die Phasen des Stators (30) angeschlossen zu sein;
   - ein hinteres Lager (40), das den Stator (30) trägt; und
   - einen Ventilator (50), der sich in der Nähe des hinteren Lagers (40) befindet.

12. Drehende elektrische Maschine nach dem vorhergehenden Anspruch, wobei die drehende elektrische Maschine (1) ein Starter-Generator ist.

13. Drehende elektrische Maschine nach dem vorhergehenden Anspruch, wobei der Starter-Generator eine Funktion zum rekuperativen Bremsen und eine Beschleunigungshilfsfunktion umfasst.

**Claims**

1. Electronic assembly (10) for a rotating electric machine (1) for a motor vehicle according to which said electronic assembly comprises:

   - blocks (100, 200, 300) of electronic components, the blocks having different heat dissipation needs, the blocks being:

      - a power bloc (100);
      - a filtering block (200);

- a control block (300);

- a cooling device (10') for cooling said blocks (100, 200, 300), said cooling device (10') comprising:

- a protective cap (400) adapted to cover the power, filtering and control blocks (100, 200, 300), said protective cap comprising apertures (401, 402, 403, 404) designed to generate different cooling air streams (F1, F2, F3, F4) for the heat dissipation needs of each of the power (100), control (300) and filtering (200) blocks; and
- cooling elements (101, 201, 301) cooperating thermally with the apertures (401, 402, 403, 404) of said protective cap (400);

- a first cooling element is a first heat sink (101) provided with a plurality of fins (1011) coupled to said power block (100);
- a second cooling element is a second heat sink (201) provided with a plurality of fins (2011), coupled to capacitors (202) of said filtering block (200);
- the control block (300) is disposed on a first plane (P1) parallel to a second plane (P2) on which the power block (100) is mounted so as to allow a passage for a cooling air stream (F2) between the two blocks (100, 300) ;
- the apertures of the protective cap (400) are divided up into:

- a first set of apertures (401) designed to be positioned facing the fins of the first heat sink (101) ;
- a second set of apertures (402) designed to be positioned facing the control block (300);
the two sets of apertures (401, 402) being separated by a separating low wall (405) so as to create a first radial cooling air stream (F1) for said power block (100) and a second radial cooling air stream (F2) for said control block (300); and
- a third set of apertures (403) designed to be positioned facing the fins of the second heat sink (201) so as to create a third radial cooling air stream (F3) for said filtering block (200).

2. Electronic assembly (10) according to Claim 1, wherein the fins of the first heat sink (101) are disposed in groups of parallel fins and the groups are disposed so as to allow a radial circulation of a cooling air stream under the power block (100).

3. Electronic assembly (10) according to either one of the preceding claims, wherein the power block (100) and the filtering block (200) are linked electrically by means of a conductive piece (101) of negative polarity.

4. Electronic assembly (10) according to the preceding claim, wherein the first heat sink (101) and the second heat sink (201) respectively comprise mounting orifices (1014-2014) designed to cooperate with one another.

5. Electronic assembly (10) according to Claim 1 or 2, wherein the assembly between the power block (100) and the filtering block (200) involves a mounting screw (204), a conductive piece (104), a thermal insulator (105) disposed between a mounting lug (1014) of the first heat sink (101) and a lower face of said conductive piece (104), a first electrical insulator (106) disposed between said conductive piece (104) and a rear bearing (40) of the rotating electric machine, and a second electrical insulator (106') disposed between a head of the mounting screw (204) and a top face of a mounting lug (2014) of the second heat sink (201).

6. Electronic assembly (10) according to Claim 1, wherein a third cooling element is a third heat sink (301) provided with a plurality of fins (3011) coupled to the control block (300).

7. Electronic assembly (10) according to the preceding claim, wherein the third heat sink (301) is coupled to components of the control block (300) by means of a resin, a metal blade, a filling seal or a gap pad.

8. Electronic assembly (10) according to any one of the preceding claims, wherein the apertures of the first set of apertures (401), of the second set of apertures (402) and of the third set of apertures (403) of the protective cap (400) are lateral, and the apertures of the first set of apertures (401) and of the second set of apertures (402) are disposed to match with the fins of the first heat sink (101).

9. Electronic assembly (10) according to any one of the preceding claims, wherein the arrangement of the fins of the first heat sink (101), of the protective cap (400) and of the apertures of the first set (401) is effected so as to satisfy the following relationships:

$$h \geq 0.5 \cdot ha$$

$$H < 0.5 \cdot ha,$$

and

$$D \geq 0.5 \cdot (d^2 - ((o-e)/2)^2)^{1/2},$$

given that h is the height of an aperture of the protective cap (400), ha is the height of a fin of the first heat sink (101), H is the distance between the bottom of the protective cap (400) and the bottom of an aperture, D is the distance between the inner edge of the protective cap (400) and the leading edge of a fin of the first heat sink (101), d is an inter-fin space separating two adjacent fins of the first heat sink (101), o is the width of an aperture and e is the thickness of a fin.

10. Electronic assembly (10) according to any one of the preceding claims, wherein the protective cap (400) further comprises a fourth set of apertures (404) situated on the top of said cap (400) designed to be positioned above the capacitors (202) of the filtering block (200) so as to create a fourth, axial cooling air stream (F4) for the filtering block (200).

11. Rotating electric machine (1) comprising:

   - a rotor;
   - a stator (30) coupled to said rotor and comprising a plurality of phases;
   - an electronic assembly (10) according to any one of the preceding claims, the power block (100) of said electronic assembly (10) being designed to be connected to the phases of said stator (30);
   - a rear bearing (40) supporting said stator (30); and
   - a fan (50) situated close to the rear bearing (40).

12. Rotating electric machine according to the preceding claim, wherein said rotating electric machine (1) is an alternator-starter.

13. Rotating electric machine according to the preceding claim, wherein said alternator-starter includes a regenerative braking function and an acceleration assist function.

Fig. 1a

300 P1

P2

100

101

Fig. 1b

100   1002

1001

1001

1012

Fig. 2

1001

103

Fig. 3a

1002

1003                    103'

Fig. 3b

Fig. 4

Fig. 5

101

1011

1013

Fig. 6

1002

1001

101

1012

40

Fig. 7

Fig. 8

Fig. 9

Fig. 10

Fig. 11

Fig. 12

Fig. 13

Fig. 14

Fig. 15

Fig. 16

Fig. 17

Fig. 18

Fig. 19

**Fig. 20**

**Fig. 21**

Fig. 22

**RÉFÉRENCES CITÉES DANS LA DESCRIPTION**

**Documents brevets cités dans la description**

- WO 13061404 A1

- FR 2847085